## Europäisches Patentamt
## European Patent Office
## Office européen des brevets

(11) Veröffentlichungsnummer: **0 141 452**
**B1**

(12) **EUROPÄISCHE PATENTSCHRIFT**

(45) Veröffentlichungstag der Patentschrift: **12.09.90**

(51) Int. Cl.⁵: **H 03 D 1/22, H 03 J 5/02, H 03 L 7/22, H 04 B 1/16**

(21) Anmeldenummer: **84201355.9**

(22) Anmeldetag: **21.09.84**

(54) Schaltungsanordnung für einen Empfänger mit zwei Phasenregelkreisen.

(30) Priorität: **28.09.83 DE 3335024**

(43) Veröffentlichungstag der Anmeldung:
**15.05.85 Patentblatt 85/20**

(45) Bekanntmachung des Hinweises auf die Patenterteilung:
**12.09.90 Patentblatt 90/37**

(84) Benannte Vertragsstaaten:
**DE FR GB**

(56) Entgegenhaltungen:
EP-A-0 088 467
GB-A-2 024 546
US-A-4 272 788
US-A-4 451 930
US-A-4 454 607

PATENT ABSTRACTS OF JAPAN, Band 4, Nr. 170 (E-35)652r, 22. November 1980 & JP-A-55-118 234

(73) Patentinhaber: **Philips Patentverwaltung GmbH Wendenstrasse 35 Postfach 10 51 49 D-2000 Hamburg 1 (DE)**
(84) **DE**

(73) Patentinhaber: **N.V. Philips' Gloeilampenfabrieken Groenewoudseweg 1 NL-5621 BA Eindhoven (NL)**
(84) **FR GB**

(72) Erfinder: **Nolde, Wolfgang Im Ginsterbusch 5 D-2000 Hamburg 61 (DE)**
Erfinder: **Jansen, Winfried Blütenweg 29 D-2081 Ellerbeck (DE)**

(74) Vertreter: **Hartmann, Heinrich, Dipl.-Ing. et al Philips Patentverwaltung GmbH Wendenstrasse 35 Postfach 10 51 49 D-2000 Hamburg 1 (DE)**

Courier Press, Leamington Spa, England.

**Beschreibung**

Die Erfindung betrifft eine Schaltungsanordnung nach dem Oberbegriff des Anspruchs 1. Als Phasenregelkreis wird dabei eine Schaltung bezeichnet, die einen in de Frequenz steuerbaren Oszillator enthält, dessen Ausgangssignal — gegebenenfalls über einen festen oder einstellbaren Frequenzteiler — einem Phasendiskriminator zugeführt wird, der dieses Signal mit einem Referenzsignal vergleicht und ein der Phasendifferenz entsprechendes Ausgangssignal erzeugt, das — vorzugsweise über ein Tiefpaßfilter — zur Steuerung der Frequenz des Oszillators dient. Für solche Phasenregelkreise hat sich die Bezeichnung "PLL-Schaltung" eingebürgert.

Mit "Pilotsignal" ist hierbei und im folgenden ein im Modulationssignal des empfangenen Signals enthaltenes Signal mit konstanter Frequenz bezeichnet — vorzugsweise der 19 kHz-Pilotton in dem Stereomultiplexsignal eines UKW-Stereo-Senders.

Eine Schaltungsanordnung der eingangs genannten Art ist bekannt — beispielsweise aus de Zeitschrift "Grundig Technische Informationen" Nr. 1/2, 1980, Seite 12, Bild 12. Der erste Phasenregelkreis enthält dabei einen zu Abstimmzwecken programmierbaren Frequenzteiler, während der zweite Phasenrgelkreis Teil eines Stereodecoders ist. Die beiden Phasenregelkreise benötigen insgesamt zwei in der Frequenz steuerbare Oszillatoren — wobei zumindest der im zweiten Phasenregelkreis enthaltene Oszillator einen Abgleich erfordert — sowie einen Referenz-Oszillator.

Aufgabe der vorliegenden Erfindung ist es, den Aufwand für eine solche Schaltung zu vereinfachen.

Ausgehend von einer Schaltungsanordnung der eingangs genannten Art wird diese Aufgabe durch die im kennzeichnenden Teil des Anspruchs 1 angegebenen Maßnahmen gelöst.

Aus der JP—A—5 705 7051 (entspricht der US—A—4 454 607, veröff. 12.6.1984) ist an sich ein FM-Empfänger mit Synthesizer-Abstimmung bekannt, deren Abstimmung mittels einer von einer CPU (Central Processing Unit) gelieferten Abstimminformation realisiert wird. Die CPU benutzt als Taktgeber einen in einem durch den 19 kHz-Stereopilot eines Stereomultiplexsignals synchronisierten Phasenregelkreis aufgenommenen spannungsgesteuerten Oszillator. Bekanntlich ist die Größe der Abstimminformation von einem in die CPU eingegebenen Wert abhängig und nicht von der genauen Frequenz des Taktgebers. Somit ist die Abstimmung dieses bekannten FM-Empfängers nicht mit dem 19 kHz-Stereopilot synchronisiert, und ist zur Stabilisierung der Abstimmfrequenz ein zusätzlicher und sehr stabiler Referenzoszillator unvermeidlich. In der EP—A—0 088 467 wird ein Empfänger mit einer Stereo PLL beschrieben, die durch ein im HF-Signal enthaltenes Pilotsignal synchronisiert wird. Diese PLL entspricht in ihrer Funktion der zweiten, oben im Zusammenhang mit Anspruch 1 genannten PLL.

Der Referenz-Oszillator de erfindungsgemäßen Schaltungsanordnung hat eine Doppelfunktion. Im ersten Phasenregelkreis ist er als Referenz-Oszillator wirksam und im zweiten Phasenregelkreis wirkt er als in der Frequenz gesteuerter Oszillator, de mti dem Pilotsignal synchronisiert wird. Infolgedessen kann de sonst für den zweiten Phasenregelkreis zusätzlich erforderliche, in der Frequenz steuerbare Oszillator ebenso entfallen wie der für diesen Oszillator erforderliche Abgleich.

Beim Empfang von Signalen, die kein Pilotsignal enthalten, wird der Referenz-Oszillator nicht synchronisiert, er schwingt also auf seiner Eigenfrequenz. Wenn dies Frequenz von derjenigen abweicht, auf der der Oszillator schwingt, wenn er durch das Pilotsignal synchronisiert wird, ändert sich auch die Frequenz des von dem ersten Phasenregelkreis der Mischstufe zugeführten Signals, d.h. es ändert sich die Abstimmung abhängig davon, ob ein Pilotsignal empfangen wird oder nicht. Um diese Änderung möglichst klein zu halten, sollte der Referenz-Oszillator eine möglichst hohe Frequenzstabilität haben, was sich z.B. durch einen Quarzoszillator erreichen läßt. Insbesondere für diesen Fall sieht eine Weiterbildung der Erfindung vor, daß die Frequenz des Oszillators wenigstens annähernd ein ganzzahliges Vielfaches der Frequenz des Pilotsignals beträgt. Die Oszillatorfrequenz kann jedoch auch ein rational-zahliges Vielfaches der Pilotfrequenz sein.

Zu Beginn der Abstimmung auf einen Sender, der ein Pilotsignal ausstrahlt, können relativ große Phasendifferenzen zwischen dem Pilotsignal und dem aus dem Referenz-Oszillator abgeleiteten Signal auftreten, was am Ausgang des Phasendiskriminators ein Signal zur Folge hat, das eine relativ starke Verstimmung des Referenz-Oszillators bewirkt. Diese Verstimmung des Referenz-Oszillators bewirkt aufgrund der vorhandenen Frequenzteiler in der Regel eine noch stärkere Verstimmung des im ersten Phasenregelkreis enthaltenen Oszillators, so daß auch die Empfängerabstimmung beeinflußt wird. Diese Beeinflussung kann so groß sein, daß auf den Sender nicht korrekt abgestimmt werden kann. Dies wird nach einer Weiterbildung der Erfindung dadurch vermieden, daß die Ausgangsspannung des Phasendiskriminators über einen Begrenzer geführt wird. Der Begrenzer begrenzt dabei die Verstimmung des Referenz-Oszillators und damit die Verstimmung des Oszillators im ersten Phasenregelkreis.

Durch diese Begrenzung kann bei starken Phasenabweichungen die Frequenz des Referenz-Oszillators jedoch nur relativ langsam mit dem Pilotsignal synchronisiert werden, was in vielen Fällen unerwünscht ist. Eine schnellere Synchronisierung läßt sich nach einer Wetierbildung der Erfindung dadurch erreichen, daß eine Schaltung zur Änderung des Frequenzteilerverhältnisses des Frequenzteilers vorgesehen ist, die über eine Schwellenwertanordnung durch das Ausgangssignal des Phasendiskriminators gesteuert wird. Diese Ausgestaltung ist indes unabhängig von der Erfindung. Sie läßt sich überall da anwenden, wo es auf ein schnelles Synchronisieren des Phasenregelkreises ankommt.

Die Erfindung wird nachstehend anhand der Zeichnung näher erläutert. Es zeigen.

Fig. 1 ein Ausführungsbeispiel der Erfindung,

Fig. 2 eine andere Ausführungsform des zweiten Regelkreises,

Fig. 3 die Ausgestaltung eines bei Fig. 2 verwendbaren Zählers mit steuerbarem Frequenzteileverhältnis, und

Fig. 4 eine Tabelle, die das statische Verhalten der bei Fig. 3 vorhandenenen logischen Verknüpfungsschaltun zeigt.

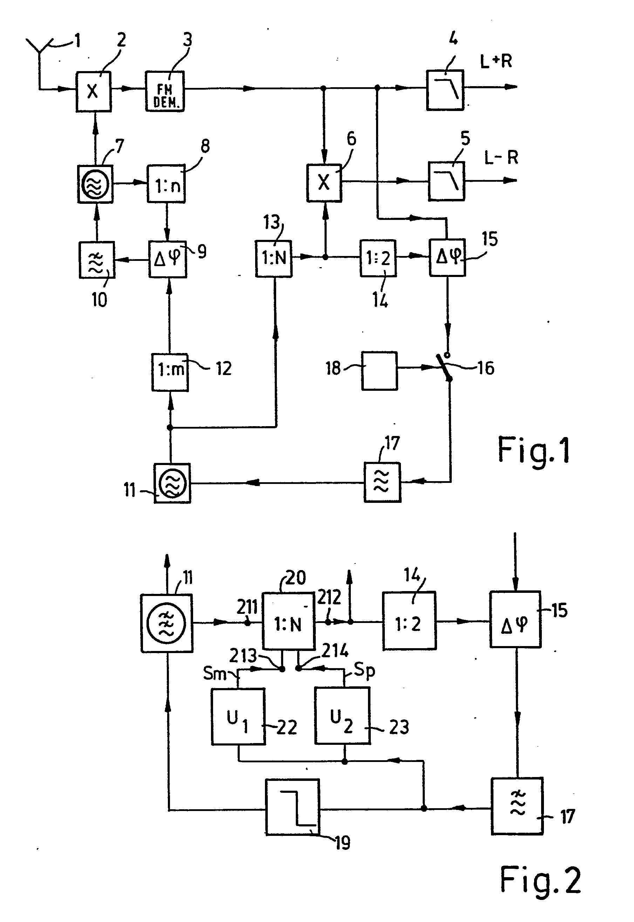

In Fig. 1 ist das Blockschaltbild eines UKW-Empfängers zum Empfang von Stereo-Signalen dargestellt. Das empfangene Signal wird von der Antenne 1 direkt oder über einen nicht näher dargestellten Vorverstärker einer Mischstufe 2 zugeführt, in de es mit einem Oszillatorsignal gemischt wird, so daß das empfangene Signal in den Zwischenfrequenzbereich umgesetzt wird — z.B. 10,7 MHz. Das Zwischenfrequenzsignal wird verstärkt und durch einen FM-Demodulator 3 demoduliert. Am Ausgang des FM-Demodulators ergibt sich das Modulationssignal im Falle einer Stereo-Sendung ein Multiplexsignal, das außer dem Summensignal für den linken (L) und den rechten Kanal (R) ein Pilotsignal von 19 kHz und ein Differenzsignal in Form zweier Seitenbänder um einen unterdrückten Hilfsträger von 38 kHz auftritt. Am Ausgang eines ersten Deemphasisgliedes 4 ergibt sich dann das Summensignal L + R, während das Differenzsignal L — R am Ausgang eines zweiten Deemphasisgliedes 5 auftritt, dem das Ausgangssignal einer Mutiplizierstufe 6 zugeführt wird, die das Multiplexsignal mit einem 38 kHz-Sinal multipliziert. die Summen- bzw. Differenzsignale am Ausgang der Deemphasisglieder 4 und 5 werden dann in gewohnter nicht näher dargestellter Weise in Signale für den linken un den rechten Kanal umgesetzt, verstärkt und über einen geeigneten akustischen Wandler wiedergegeben.

Das Oszillatorsignal für die Mischstufe 2 wird von dem in der Frequenz steuerbaren Oszillator 7 eines ersten Phasenregelkreises erzeugt. Der erste Phasenregelkreis enthält außerdem einen einstellbaren. Frequenzteiler 8, der die Oszillatorfrequenz entsprechend einem einstellbarn Faktor n untersetzt sowie einen Phasendiskriminator 9, der das in der Frequenz untersetzte Oszillatorsignal mit einem Bezugssignal mit konstanter Frequenz in der Phase vergleicht und an seinem Ausgang ein Signal liefert, das der Phasendifferenz zwischen beiden Signalen entspricht und das über einen Tiefpaß 10 dem Steuereingang des durch die Spannung an seinem Steuereingang in der Frequenz steuerbaren Oszillators 7 zugeführt wird. Die Frequenz wird dabei so lange variiert, bis die Phasendifferenz am Ausgang des Phasendiskriminators 9 praktisch gleich Null geworden ist und de Oszillator 7 mit dem Bezugssignal synchronisiert ist.

Das Bezugssignal wird mittels eines Referenz-Oszillators 11 erzeugt, dessen Frequenz ein ganzzahliges Vielfaches der Frequenz ders Pilotsignals beträgt, z.B. 4,56 MHz. Das Ausgangssignal des Referenz-Oszillators wird durch einen Frequenzteiler 12 im Verhältnis 1/m in der Frequenz untersetzt, und das untersetzte Signal wird als Bezugssignal dem Phasendiskriminator 9 zugeführt. Die Frequenz des Oszillators 7ist dann im synchronisierten Zustand das n/m-fache der Frequenz des Referenz-Oszillators, 11. Insoweit als bisher beschrieben ist der Stereo-Empfänger nach Fig. 1 im wesentlichen bekannt. Im Gegensatz zum stand der Technik ist bei der Erfindung der Referenz-Oszillator jedoch als in der Frequenz elektronisch steuerbarer Oszillator ausgebildet und in einen zweiten Phasenregelkreis aufgenommen, der das Hilfsträgersignal (38 kHz) erzeugt.

Dieser zweite Phasenregelkreis enthält außer dem Referenz-Oszillator 11 einen Frequenzteiler 13, der die Frequenz des Ausgangssignals des Referenz-Oszillators 11 im Verhältnis 1/N untersetzt, wobei N konstant ist und für den angegebenen Wert der Oszillatorfrequenz (4,56 MHz) 240 beträgt, so daß die Oszillatorfrequenz auf den Wert 38 kHz untersetzt wird. Das Ausgangssignal des Frequenzteilers 13 wird einerseits in der Multipliziertstufe 6 mit dem Multiplexsignal vom Ausgang des FM-Demodulators 3 multipliziert und andererseits durch einen weiteren Frequenzteiler 14 im Verhältnis 1:2 in der Frequenz untersetzt, so daß am Ausgang dieses Frequenzteilers ein 19 kHz-Signal anliegt.

Dieses wird in einem Phasendiskriminator 15 mit dem im Ausgangssignal des FM-Demodulators 3 enthaltenen Pilotsignal vergleichen. Die Ausgangsspannung des Phasendiskriminators, deren Amplitude oder Tastverhältnis der Phasendifferenz entspricht, wird über einen Schalter 16, der bei Mono-Empfang geöffnet und bei Stereo-Empfang geschlossen ist, einem Tiefpaß 17 zugeführt, desen Ausgang mit dem Steuereingang des Referenz-Oszillators 11 verbunden ist, so daß die Frequenz des Oszillators 11 entsprechend dem Ausgangssignal des Phasendiskriminators 15 gesteuert wird.

Der Referenz-Oszillator 11 ist vorzugsweise ein Quarzoszillator. Die Frequenz eines Quarzoszillators kann dann beispielsweise mit einer Kapazitätsdiode gesteuert werden, die in bezug auf den Quarz in gleicher Weise geschaltet ist wie sonst Ziehkondensatoren geschaltet werden, die also beispielsweise in Serie zum Schwingquarz wirksam ist. Ein solcher Oszillator hat zwar nur einen relativ kleinen Verstimmungsbereich, der jedoch völlig ausreicht, wenn die Oszillatorfrequenz einem ganzzahligen Vielfachen der Frequenz des Pilotsignals entspricht. De Schalter 16 wird durch einen in Stereo-Empfängern ohnehin erforderlichen Pilotsignaldetektor 18 geschaltet, der den Schalter 16 immer dann schließt, wenn ein Pilotsignal detektiert wird und ihn ansonsten geöffnet hält. Ein solche Pilotsignaldetektor bedeutet keinen zusätzlichen Aufwand, da er wie erwähnt in einem Stereo-Empfänger ohnehin erforderlich ist.

Die Schaltung arbeitet folgendermaßen: Bei Mono-Empfang ist der Schalter 16 geöffnet und der Oszillator 11 nicht synchronisiert. Er liefert dem ersten Phasenregelkreis dann ein Signal mit einer Frequenz von 4,56 MHz, deren Stabilität durch die Eigenschaften des Quarzes bestimmt wird. — Bei Stereo-Empfang ist der Schalter 16 geschlossen und der Referenz-Oszillator 11 wird durch die Frequenz des im Multiplexsignal enthaltenen Pilotsignals synchronisiert. Die Frequenzstabilität des Referenz-Oszillators hängt in diesem Fall von der Frequenzstabilität des vom Sender ausgestrahlten Pilotsignals ab. Da diese Frequenz um etwa $\pm$ 1 Hz schwanken kann, entspricht, dies im UKW-Bereich (100 MHz) einer möglichen Frequenzänderung von $\pm$ 5 kHz. Derart geringe Frequenzverschiebungen stören den Betrieb des Empfängers nach Fig. 1 nicht.

Wenn der Phasendiskriminator 15 als Multiplizierstufe ausgebildet ist, enthält sein Ausangssignal einen Wechselspannungsanteil, der durch die Multiplikation des 19 kHz Ausgangssignals des Frequenzteilers 14 mit im Multiplexsignal enthaltenen Frequenzkomponenten (z.B. 15 kHz) entsteht und der durch den Tiefpaß 17 unterdrückt wird. Außerdem wird der Gleichstromarbeitspunkt eines solchen Phasendiskriminators entsprechend der Phasendifferenz zwischen dem Ausgangssignal des Frequenzteilers 14 und dem Multiplexsignal enthaltenen Pilotsignal verschoben, was eine entsprechende Frequenzverschiebung des Oszillators 11 zur Folge hat. Wenn in dem Multiplexsignal kein Pilotsignal enthalten wäre, würde sich bei einem idealen Phasendiskriminator am Ausgang keine Gleichspannungsverschiebung ergeben, so daß auch die Frequenz des Referenz-Oszillators nicht verschoben würde. In diesem Fall könnte der Schalter 16 in der Verbindungsleitung zwischen dem Phasendiskriminator 15 und dem Tiefpaß 17 entfallen. Reale Phasendiskriminatoren zeigen jedoch an ihrem Ausgang einen Offset, so daß die Frequenz des Oszillators 11 selbst dann veschoben würde, wenn kein Pilotsignal vorhanden wäre. Diese Verschiebung könnte die Abstimmung durch den ersten Phasenregelkreis in unzulässiger Weise beeinflussen, und deshalb is der Schalter 16 vorgesehen. Eine andere Möglichkeit besteht jedoch darin, die maximal mögliche Frequenzverschiebung, d.h. die Amplitude am Ausgang des Tiefpaßfilters 17, zu begrenzen auf einen Wert, der die Funktion des Empfängers nicht beeinträchtigt. In diesem Fall kann de Schalter 16 ebenfalls entfallen.

Fig. 2 zeigt das Blockschaltbild des auf diese Weise modifizierten zweiten Phasenregelkreises, wobei wiederum dieselben Bezugszeichen für die gleichen Bauteile verwendet sind. Das Ausgangssignal des Phasendiskriminators 15 wird dem Tiefpaß dabei direkt zugeführt, und der Ausgang des Tiefpasses 17 ist über einen Begrenzer 19 mit dem Seuereingang des Oszillators 11 verbunden. Dadurch wird ebenfalls die maximal mögliche Verstimmung des Referenz-Oszillators begrenzt, so daß diese keine die Abstimmung störenden Wert annehmen kann. Auf der anderen Seite hat diese Begrenzung aber zur Folge, daß de Zeitraum, der erforderlich ist, um den Oszillator 11 mit dem Pilotsignal zu synchronisieren, verlängert wird. Dieser durch den Einsatz des Begrenzers 19 hervorgerufene Nachteil läßt sich indes dadurch beseitigen, daß anstelle des Frequenzteilers 13 mit festem Frequenzateilerverhältnis ein Frequenzateiler 20 mit elektronisch steuerbarem Frequenzteilerverhältnis benutzt wird, dessen Eingang 211 mit dem Ausgang des Oszillators und dessen Ausgang 212 mit dem Eingang des 1:2 Frequenzteilers 14 verbunden ist. DAs Frequenzteilerverhältnis wird mit Hilfe von zwei Komparatoren 22 und 23 gesteuert, deren Eingänge mit dem Ausgang des Tiefpaßfilters verbunden sind und deren Ausgänge mit einem Steuereingang 213 bzw. 214 des Frequenzteilers 20 verbunden sind.

Liegt die Ausgangsspannung des Tiefpasses 17 in einem Bereich zwischen den Grenzen $U_1$ und $U_2$, sind die Ausgangssignale $s_m$ und $s_p$ der Komparatoren 22, 23 Null. In diesem Fall ist der Frequenzteilerfaktor des Frequenzteilers 20 gerade 120. Die Werte $U_1$ und $U_2$ liegen vorzugsweise so, daß derjenige Wert der Ausgangsspannung des Tiefpaßfilters 17, bei dem keinerlei Verstimmung des Oszillators 11 erfolgt, genau in der Mitte liegt. Sie sollten zwischen denjenigen Werten liegen, bei denen eine Begrenzung durch den Begrenzer 19 erfolgt. Liegt die Ausgangsspannung am Tiefpaß 17 oberhalb von $U_1$ und von $U_2$, ist das Signal $s_m$ am Eingang 213 gleich 1 und das Signal $s_p$ am Eingang 214 gleich 0. In diesem Fall wird der Frequenzteilerfaktor auf den Wert 118 herabgesetzt. Ist hingegen die Ausgangsspannung des Tiefpasses 17 kleiner als $U_1$ und $U_2$, ist $s_p$ gleich 1 und $s_m$ gleich 0. In diesem Fall wird der Frequenzteilerfaktor auf den Wert 122 heraufgesetzt. In beiden Fällen ändert sich die Frequenz des Ausgangssignals um etwa 320 Hz. Selbst wenn also im ungünstigsten Fall die Phasenverschiebung 180° betragen würde, wären das Ausgangssignal des Frequenzteilers 15 und das Pilotsignal in wenigen ms in der Phase synchronisiert; ohne die Veränderung des Frequenzteilerfaktors wären hingegen rund 500 ms erforderlich, falls die Verstimmung des Oszillators auf etwa $5 \times 10^{-5}$ begrenzt würde.

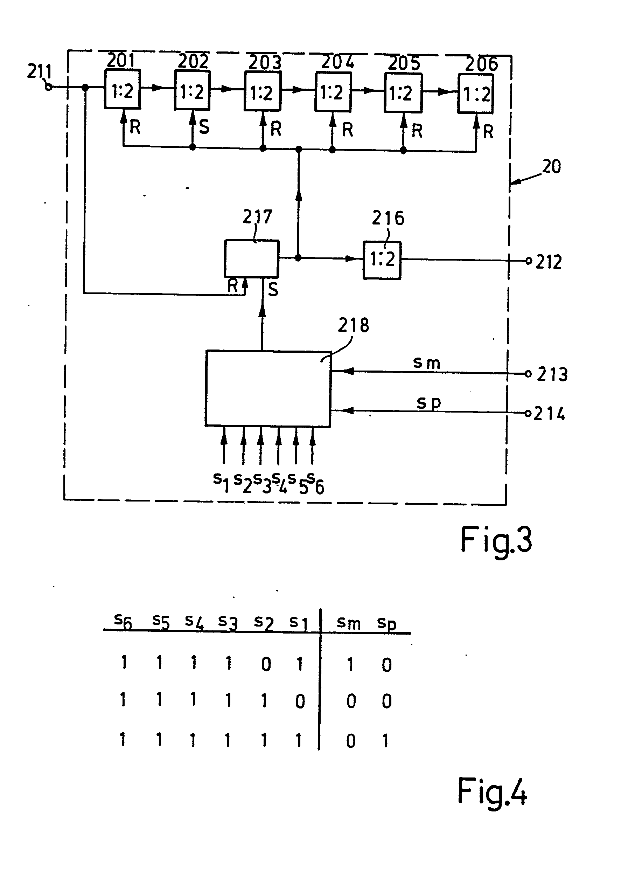

Fig. 3 zeigt zeigt ein Ausführungsbeispiel für den Frequenzteiler 20. Er enthält sechs in Serie geschaltete 1:2-Frequenzteiler, die vorzugsweise durch ein sogenanntes Toggle-Flipflop (Tietze/ Schenck "Halbleiter-Schaltungstechnik", 4. Auflage 1978, Seite 166) gebildet werden und die negativ-flankengetriggert sind. Außer der Kette der Frequenzteilerzone 1 ... 206 wird das Signal am Eingang 211 einem Inverter 215 zugeführt, dessen Ausgang mit dem Rücksetzeingang eines RS-Flipflops verbunden ist, dessen Ausgang wiederum mit dem Takteingung eines weiteren Toggle-Flipflops 216 verbunden ist. Der Ausgang dieses Toggle-Flipflops stellt den Ausgang 212 des Frequenzteilers 20 dar. Der Setzeingang des RS-Flipflops 217 ist mit dem Ausgang einer logischen Verknüpfungsschaltung 218 verbunden, die die Ausgangssignale $s_1$ ... $s_6$ der Frequenz-

teiler 201 ... 206 sowie die Ausgangssignale $s_m$, $s_p$ der Komparatoren 22 und 23 verknüpft.

Der Ausgang des RS-Flipflops 217 außerdem mit den Rücksetzeingängen R der Frequenzateiler 201 sowie 203 ... 206 sowie mit dem Setzeingang S des Frequenzteilers 202 verbunden. Für den Fall, daß der Ausgangszustand der logischen Verknüpfungsschaltung dem logischen Signal "1" entspricht, sind die Ausgänge der Frequenzteiler-Flipflops 201 und 203 ... 206 "0" und der Ausgang des Flipflops 202 "1". Verknüpft man die Ausgangssignale $s_6$ .. $s_1$ der Frequenzteiler 206 ... 201 zu einem sechssteiligen binären Datenwort, bei dem die höherwertigere Binärstelle der niedrigerwertigen Binärstelle vorangeht ($s_6$ hat die höchste Wertigkeit — $s_1$ die niedrigste), dann entspricht dieser Schaltzusand dem Datenwort 000010. Im dekadischen System entspricht dies der Zahl 2.

Zur Erläuterung der Funktion der Schaltung nach Fig. 3 sei angenommen, daß der zweite Phasenregelkreis synchronisiert ist, so daß $s_m = s_p = 0$ gilt. Es sei weiterhin angenommen, daß zu einem bestimmten Zeitpunkt de aus den Frequenzteiler-Flipflops 201 ... 206 bestehende Zähler einen bestimmten Zählerstand erreicht habe. Mi jeder weiteren Periode der Schwingung des Oszillatorsignals erhöht sich dann der Zählerstand jeweils um 1, bis ein Zählerstand erreicht ist, der dem Datenwort 111110 (dekadisch: 62) entspricht. Wie hierzu der in Fig. 4 dargestellten Tabelle zu entnehmen ist, die diejenigen Kombinationen von $s_6$ ... $s_1$, $s_m$, $s_p$ darstellt, für die das Ausgangssignal der logischen Verknüpfungsschaltung 218 "1" wird (bei allen anderen Kombinationen ist es "0"), wird das Ausgangssignal der logischen Verknüpfungsschaltung dann "1", so daß der Zähler 201 ... 206 entsprechend dem Anschluß de Setz- bzw. Rücksetz-Eingänge auf 000010 (dekadisch: 2) zurückgesetzt wird. Es liegen dann nicht mehr die Bedingungen vor, bei denen das Ausgangssignal der logischen Verknüpfungsschaltung "1" ist, so daß de Zähler dann von 000010 ausgehend wiederum auf 111110 hochzählt, wonach sich der schon beschriebene Vorgang wiederholt. De Zähler zählt also nur 60 Impulse und nur alle 60 Impulse erscheint am Ausgang des RS-Flipflops 217 ein 1-0-Übergang, d.h. eine negative Flanke, so daß die Periode des Signals am Ausgang 212 gerade 120 Perioden am Eingang 211 entspricht.

Wenn in dem Phasenregelkreis gemäß Fig. 2 eine größere Phaendifferenz zwischen dem Ausgangssignal des Frequenzteilers 14 und dem Pilotsignal vorliegt, spricht beispielsweise der Komparator 22 an ($s_m = 1$; $s_p = 0$). In diesem Fall zählt de Zähler 201 ... 206 ebnfalls jeden Impuls, jedoch nur bis ein Zählerstand 111101 (dekadisch: 61) erreicht ist. In diesem Fall beträgt die Periodendauer am Ausgang 212 2 × (61-2) = 118 Perioden des Signals am Eingang 211. — Wenn die Phasendifferenz gegenüber dem angenommenen Fall das entgegengesetzte Vorzeichen hätte, würde $s_m = 0$ und $s_p = 1$ gelten. In diesem Fall würde de Zähler bis 111111 (dekadisch: 63) zählen und die Periode des Signals am Ausgang 212 würde 122 Perioden des Eingangssignals 211 dauern.

## Patentansprüche

1. Schaltungsanordnung für einen Empfänger mit einem ersten Phasenregelkreis (7 ... 10), der mit einem Referenz-Oszillator synchronisiert wird und ein Signal liefert, das einer Mischstufe zugeführt wird, die das empfangene HF-Signal auf eine Zwischenfrequenz umsetzt, und mit einem zweiten Phasenregelkreis (13 ... 17), der durch ein in dem Modulationssignal des empfangenen HF-Signals enthaltenes Pilotsignal synchronisiert wird, dadurch gekennzeichnet, daß in den zweiten Phasenregelkreis (13 ... 17) ein in der Frequenz elektronisch steuerbarer, auf das Pilotsignal synchronisierbarer Oszillator (11) aufgenommen ist, de den Referenzoszillator des ersten Phasenregelkreises (7 ... 10) bildet.

2. Schaltungsanordnung nach Anspruch 1, dadurch gekennzeichnet, daß die Frequenz des Oszillators (11) wenigstens annähernd ein ganzzahliges Vielfaches der Frequenz des Pilotsignals beträgt.

3. Schaltungsanordnung nach einem der vorhergehenden Ansprüche, dadurch gekennzeichnet, daß der Ausgang des Referenz-Oszillators (11) in dem zweiten Regelkreis über einen Frequenzteiler (13, 14) mit dem einen Eingang eines Phasendiskriminators (15) verbunden ist, dessen anderem Eingang das Pilotsignal zugeführt wird und dessen Ausgang über einen Tiefpaß (17) mit dem Steuereingang des Referenz-Oszillators (11) zur Steuerung seiner Frequenz verbunden ist.

4. Schaltungsanordnung nach Anspruch 3, dadurch gekennzeichnet, daß zwischen dem Ausgang des Phasendiskriminators (15) und dem Eingang des Tiefpasses (17) ein Schalter (16) angeordnet ist, dessen Schaltzustand durch einen Pilotsignaldetektor (18) gesteuert ist.

5. Schaltungsanordnung nach einem der vorhergehenden Ansprüche, dadurch gekennzeichnet, daß die Ausgangsspannung des Phasendiskriminators (15) über einen Begrenzer (19) zugeführt wird.

6. Schaltungsanordnung nach Anspruch 5, dadurch gekennzeichnet, daß eine Schaltung (20) zur Änderung des Frequenzteilerverhältnisses des Frequenzteilers vorgesehen ist, die über eine Schwellenwertanordnung (22, 23) durch das Ausgangssignal des Phasendiskriminators (15) gesteuert wird.

7. Schaltungsanordnung nach einem der vorhergehenden Ansprüche, dadurch gekennzeichnet, daß der Referenz-Oszillator (11) über einen Frequenzteiler (12) mit dem ersten Phasenregelkreis (7 ... 10) verbunden ist.

8. Schaltungsanordnung nach einem der vorhergehenden Ansprüche, dadurch gekennzeichnet, daß der erste Phasenregelkreis (7 ... 10) einen Frequenzteiler (8) mit elektronisch steuerbarem Frequenzteilerverhältnis enthält.

## Revendications

1. Montage de circuit destiné à récepteur comprenant un premier circuit de régulation de phase (7 ... 10) qui est synchronisé avec un oscillateur de référence et fournit un signal appliqué à un étage mélangeur, qui convertit le signal HF reçu vers une fréquence intermédiaire et comportant un deuxième circuit de régulation de phase (13 ... 17) qui est synchronisé par un signal pilote contenu dans le signal de modulation du signal HF reçu, caractérisé en ce qu'un oscillateur (11) synchronisable sur le signal pilote, qui peut être commandé en fréquence par voie électronique et qui forme l'oscillateur de référence du premier circuit de régulation de phase (7 ... 10), est incorporé dans le deuxième circuit de régulation de phase (13 ... 17).

2. Montage de circuit suivant la revendication 1, caractérisé en ce que la fréquence de l'oscillateur (11) est au moins à peu près égale à un multiple entier de la fréquence du signal pilote.

3. Montage de circuit suivant l'une quelconque des revendications précédentes, caractérisé en ce que la sortie de l'oscillateur de référence (11), dans le deuxième circuit de régulation, est connectée, par l'intermédiaire d'un diviseur de fréquence (13, 14) à l'une des entrées d'un discriminateur de phase (15), dont l'autre entrée reçoit le signal pilote et dont la sortie est connectée, par l'intermédiaire d'un filtre passe-bas (17), à l'entrée de commande de l'oscillateur de référence (11) pour en commander la fréquence.

4. Montage de circuit suivant la revendication 3, caractérisé en ce qu'un interrupteur (16), dont l'état de commutation est commandé par un détecteur de signal pilote (18) est monté entre la sortie du discriminateur de phase (15) et l'entrée du filtre passe-bas (17).

5. Montage de circuit suivant l'une quelconque des revendications précédentes, caractérisé en ce que la tension de sortie du discriminateur de phase (15) est appliquée par l'intermédiaire d'un limiteur (19).

6. Montage de circuit suivant la revendication 5, caractérisé en ce qu'il comporte un circuit (20) servant à modifier le rapport de division de fréquence du diviseur de fréquence, qui est commandé par le signal de sortie du discriminateur de phase (15), par l'intermédiaire d'un dispositif à valeur de seuil (22, 23).

7. Montage de circuit suivant l'une quelconque des revendications précédentes, caractérisé en ce que l'oscillateur de référence (11) est connecté par l'intermédiaire d'un diviseur de fréquence (12), au premier circuit de régulation de phase (7 ... 10).

8. Montage de circuit suivant l'une quelconque des revendications précédentes, caractérisé en ce que le premier circuit de régulation de phase (7 ... 10) contient un diviseur de fréquence (8), dont le rapport de division de fréquence peut être commandé par voie électronique.

## Claims

1. A circuit arrangement for a receiver comprising a first phase control Loop (7 ... 10) which is synchronized with a reference oscillator and supplies a signal which is applied to a mixer stage which converts the received RF-signal to an intermediate frequency, and a second phase control loop (13 ... 17) which is synchronized by a pilot signal contained in the modulating signal of the received RF-signal, characterized in that the second phase control loop (13 ... 17) incorporates an oscillator (11) whose frequency is electronically controllable and which can be synchronized on the pilot signal, said oscillator constituting the reference oscillator of the first phase control loop (7 ... 10).

2. A circuit arrangement as claimed in Claim 1, characterized in that the frequency of the oscillator (11) is at least substantially an integral multiple of the frequency of the pilot signal.

3. A circuit arrangement as claimed in any one of the preceding Claims, characterized in that the output of the reference oscillator (11) in the second control loop is connected *via* a frequency divider (13, 14) to one input of a phase discriminator (15), whose other input receives the pilot signal and whose output is connected *via* a low-pass filter (17) to the control input of the reference oscillator (11) for controlling its frequency.

4. A circuit arrangement as claimed in Claim 3, characterized in that a switch (16) whose switching state is controlled by a pilot signal detector (18) is arranged between the output of the phase discriminator (15) and the input of the low-pass filter (17).

5. A circuit arrangement as claimed in any one of the preceding Claims, characterized in that the output voltage of the phase discriminator (15) is supplied *via* a limiter (19).

6. A circuit arrangement as claimed in Claim 5, characterized in that a circuit (20) for changing the frequency divider ratios of the frequency dividers is provided, which is controlled by the output signal of the phase discriminator (15) *via* a threshold arrangement (22, 23).

7. A circuit arrangement as claimed in any one of the preceding Claims, characterized in that the reference oscillator (11) is connected to the first phase control loop (7 ... 10) *via* a frequency divider (12).

8. A circuit arrangement as claimed in any one of the preceding Claims, characterized in that the first phase control loop (7 ... 10) comprises a frequency divider (8) having an electronically controllable frequency divider ratio.

Fig.1

Fig.2

Fig.3

| $s_6$ | $s_5$ | $s_4$ | $s_3$ | $s_2$ | $s_1$ | $s_m$ | $s_p$ |
|-------|-------|-------|-------|-------|-------|-------|-------|
| 1 | 1 | 1 | 1 | 0 | 1 | 1 | 0 |
| 1 | 1 | 1 | 1 | 1 | 0 | 0 | 0 |
| 1 | 1 | 1 | 1 | 1 | 1 | 0 | 1 |

Fig.4